# EUROPEAN PATENT APPLICATION

(11) **EP 3 382 837 A1**
(43) Date of publication of application: **03.10.2018**
(21) Application number: 18162912.2
(22) Date of filing: 20.03.2018
(51) Int. Cl.: H02H 7/08, H02P 29/60

(54) **A HEALTH MONITORING SYSTEM HAVING A POWER CONVERTER CONTROLLER FOR AN ELECTRIC MACHINE**

(30) Priority: 27.03.2017 US 201715470791
(71) Applicant: GE Energy Power Conversion Technology Ltd, Rugby Warwickshire CV21 1BU (GB)
(72) Inventor: SOLOMON, Luke, Pittsburgh, PA 15238 (US); DOMINGUEZ, Sergio, Rugby, Warwickshire CV21 1BU (GB); DOUCETTE, Michael Richard, Pittsburgh, PA 15238 (US); SIEMAN, Alexander, Pittsburgh, PA 15238 (US)
(74) Representative: Fischer, Michael Maria

(57) **Abstract**

Provided is a health monitoring system (100) for an electric machine (150) that includes a power converter (120) which receives power from an electric power supply, supplies power to the electric machine (150), and receives operational data from the electric machine (150). At least one power converter computing unit (130) is disposed within the power converter (120) and includes one or more software modules (136, 137) for performing control for the power converter (120) and diagnostics of the electric machine (150).

## Description

### TECHNICAL FIELD

The present invention relates generally to an electric converter controller for an electric machine. In particular, the present invention relates a health monitoring system including a power converter controller to determine performance and health status of the electric machine.

### BACKGROUND

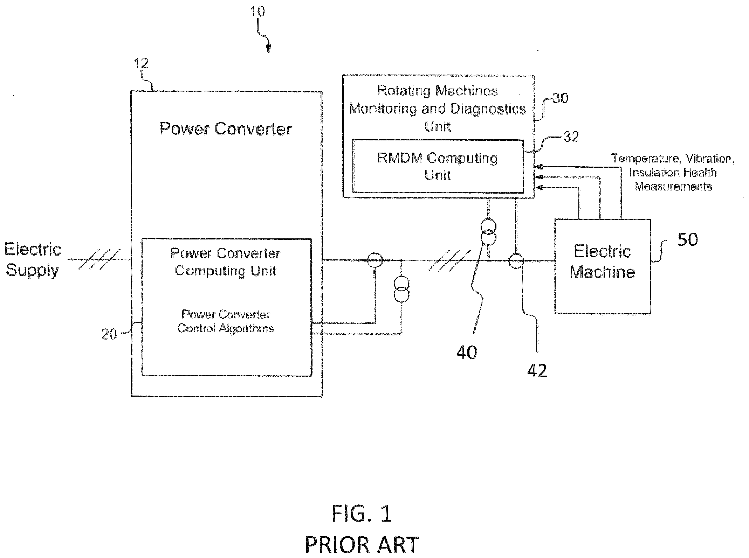

A conventional electric machine health monitoring system is system 10, shown in FIG. 1. The system 10 typically includes a power converter 12, and a power converter computing unit 20. The power converter computing unit 20 executes at least one software module including power converter control techniques. The system 10 further includes a separate, dedicated rotating machine monitoring and diagnostic unit 30 including a processing unit 32 executing at least one software module for monitoring and other diagnostic techniques for an electric machine 50.

The system 10 also includes at least one sensor 40 and 42 for obtaining information, such as voltage and current measurements, of the electric machine 50 along with additional information e.g., temperature and vibration data to be used as input to the rotating machine monitoring and diagnostic unit 30. The power converter 12 obtains operational data including without limitation voltage and current measurements from at least one sensor which is separate from the sensors used by monitoring and diagnostic unit 30.

The conventional system 10 requires a separate set of sensors and a separate computing unit 32 for performing the diagnostics for the electric machine 50. Therefore, this system 10 requires duplicate computing units and duplicate sensors which further increases hardware and development costs.

### BRIEF DESCRIPTION

Given the aforementioned deficiencies, there is a need for a health monitoring system for an electric machine which includes a software module for diagnostic software techniques within the power converter system. By embedding the software techniques inside the power converter system, these techniques can be performed and the health of an electric machine can be determined without any additional sensors, data acquisition, or computational processing hardware.

In embodiments of the present invention, a health monitoring system for an electric rotating machine is provided. The health monitoring system includes a power converter which receives power from an electric power supply and which receives operational data from the electric rotating machine. The power converter contains at least one power converter computing unit and includes one or more software modules for performing control for the power converter and diagnostics of the electric rotating machine.

In other embodiments of the present invention, a power converter is provided. The power converter includes at least one power converter computing unit having one or more software modules. The power converter receives power from an electric power supply and receives operational data from the electric machine via sensors in communication with the electric machine, and performs control of the power converter and diagnostics of the electric machine using the one or more software modules.

The foregoing has broadly outlined some of the aspects and features of various embodiments, which should be construed to be merely illustrative of various potential applications of the disclosure. Other beneficial results can be obtained by applying the disclosed information in a different manner or by combining various aspects of the disclosed embodiments. Accordingly, other aspects and a more comprehensive understanding may be obtained by referring to the detailed description of the exemplary embodiments taken in conjunction with the accompanying drawings, in addition to the scope defined by the claims.

### BRIEF DESCRIPTION OF THE DRAWINGS

FIG. 1 is a schematic of a conventional health monitoring system for an electric machine.
FIG. 2 is a schematic of a health monitoring system including a power converter for an electric machine that can be implemented within one or more embodiments of the present invention.
FIG. 3 is a block diagram illustrating a power converter computing unit that can be implemented within one or more embodiments of the present invention.
FIG. 4 is a flow diagram illustrating a method for performing health monitoring and machine performance of an electric machine that can be implemented within one or more embodiments of the present invention.
FIG. 5 is a flow diagram illustrating a method for performing health monitoring and machine performance of an electric machine that can be implemented within one or more embodiments of the present invention.

The drawings are only for purposes of illustrating preferred embodiments and are not to be construed as limiting the disclosure. Given the following enabling description of the drawings, the novel aspects of the present disclosure should become evident to a person of ordinary skill in the art. This detailed description uses numerical and letter designations to refer to features in the drawings. Like or similar designations in the drawings and description have been used to refer to like or similar parts of embodiments of the invention.

### DETAILED DESCRIPTION

As required, detailed embodiments are disclosed herein. It must be understood that the disclosed embodiments are merely exemplary of various and alternative forms. As used herein, the word "exemplary" is used expansively to refer to embodiments that serve as illustrations, specimens, models, or patterns. The figures are not necessarily to scale and some features may be exaggerated or minimized to show details of particular components.

In other instances, well-known components, apparatuses, materials, or methods that are known to those having ordinary skill in the art have not been described in detail in order to avoid obscuring the present disclosure. Therefore, specific structural and functional details disclosed herein are not to be interpreted as limiting, but merely as a basis for the claims and as a representative basis for teaching one skilled in the art.

As noted above, the embodiments provide a health monitoring system that includes diagnostic techniques within the existing power converter that is already collecting the voltages and currents of the electric machine, these techniques can be run and the health of an electric machine can be determined without any additional sensor, data acquisition, or computational processing hardware. A method is further provided that includes using at least one sensor to perform control of the power converter and to obtain information for determining machine performance and health status, locally within the power converter.

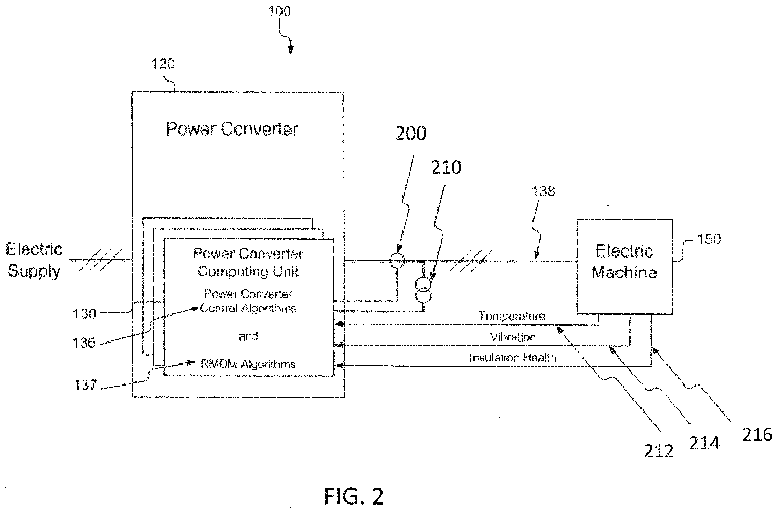

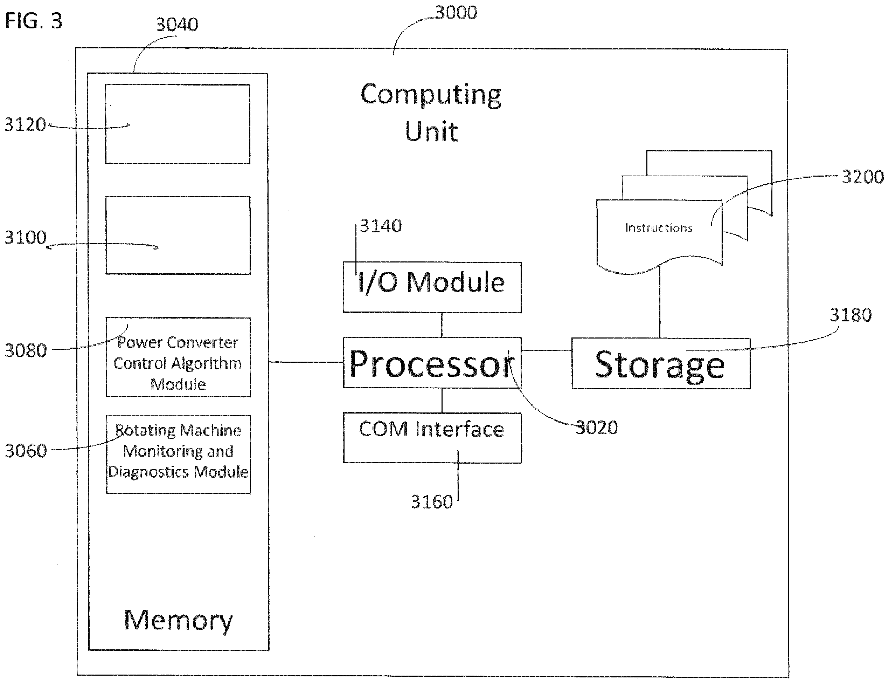

The health monitoring system according to one or more embodiments of the present invention will now be described with reference to FIGS. 2 and 3.

FIG. 2 is a schematic of a health monitoring system 100 according to one or more embodiments of the present invention. As shown, the health monitoring system 100 includes a power converter 120 (e.g., an AC/AC, DC/AC, AC/DC or DC/DC power converter). The power converter 120 includes a power converter computing unit 130.

The power converter computing unit 130 includes at least one software module 136 for performing control of the power converter 120 and also includes at least one software module 137 for performing diagnostics (e.g., health status and machine performance) of the electric machine 150. According to one or more embodiments, the power converter 120 can include a plurality of power converter computing units 130 each performing different power converter control algorithms and one or more software modules 137 for performing diagnostics of the electric machine 150.

The power converter 120 receives power from an electric power supply and then supplies converted power to the electric machine 150 by a single bus 138 via at least one wire. The system 100 further includes sensors 200, 210 for obtaining operational information, such as voltage and current measurements, of the electric machine 150 along with additional sensors 212, 214 and 216 for diagnosing temperature and vibration data and insulation health of the electric machine 150.

FIG. 3 shows a block diagram of a power converter computing unit 3000, which could be implemented as power converter computing unit 130. The power converter computing unit 3000 can include a processor 3020 that has a specific structure. The specific structure is imparted to the processor 3020 by instructions stored in a memory 3040 included therein and/or by instructions 3200 that can be fetched by the processor 3020 from a storage medium 3180. The storage medium 3180 may be co-located with computing unit 3000 as shown, or it maybe located elsewhere and be communicatively coupled to the computing unit 3000. The power converter computing unit 3000 is contained in the power converter system.

The computing unit 3000 may include one or more hardware and/or software components configured to fetch, decode, execute, store, analyze, distribute, evaluate, diagnose, and/or categorize information. Furthermore, the computing unit 3000 can include an (input/output) I/O module 3140 that can be configured to interface with a plurality of remote devices including sensors.

The processor 3020 may include one or more processing devices or cores (not shown). In some embodiments, the processor 3020 may be a plurality of processors, each having either one or more cores. The processor 3020 can be configured to execute instructions fetched from the memory 3040, i.e. from one of memory block 3120, memory block 3100, memory block 3080, or memory block 3060, or the instructions may be fetched from storage medium 3180, or from a remote device connected to computing unit 3000 via communication interface 3160.

Furthermore, without loss of generality, the storage medium 3180 and/or the memory 3040 may include a volatile or non-volatile, magnetic, semiconductor, tape, optical, removable, non-removable, read-only, random-access, or any type of non-transitory computer-readable computer medium. The storage medium 3180 and/or the memory 3040 may include programs and/or other information that may be used by the processor 3020. Moreover, the storage medium 3180 may be configured to log data processed, recorded, or collected during the operation of the computing unit 3000. For example, the storage medium 3180 may store historical patterns, predetermined thresholds, for each of the measurable variables associated with one or more electric machines coupled to the computing unit 3000. The data may be time-stamped, location-stamped, cataloged, indexed, or organized in a variety of ways consistent with data storage practice.

In one embodiment, for example, the memory block 3060 may be a rotating machine monitoring and diagnostic module, and the memory block 3080 may be a power converter control algorithm module. As such, the computing unit 3000 may fetch instructions from these modules, which, when executed by the processor 3020, cause the processor 3020 to perform certain operations.

The operations may include receiving status data from an electric machine coupled to the computing unit 3000. The operations may further include using the status data to both perform a diagnostics test of the electric machine as well alter the control regimen of the power converter.

The status data may include measured data associated with at least one of voltage and current of the electric machine. The diagnostics test may include comparing the status data with either a historical pattern or a predetermined threshold, or both, based on information stored in the storage medium 3180.

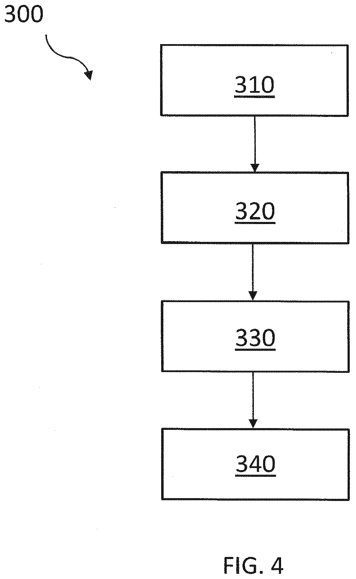

A method 300 of FIG. 4 for performing health monitoring and machine performance of the electric machine 150 will now be discussed with reference to the health monitoring system 100 shown in FIGS. 2 and 3.

This method 300 leverages existing sensor data and processing capability that is already present to provide primary power converter control and to run diagnostic algorithms to determine electric machine performance and health status. The method begins at operation 310, where electric power is supplied to the electric machine via the power converter and the power converter computing unit receives operational data from the electric machine via at least one sensor in communication with the electric machine.

From operation 310, the process continues to operation 320, where the operational data is transmitted to a data acquisition unit locally within the power converter computing unit. From operation 320, the process continues to operation 330 where the power converter is controlled using control algorithms within at least one software module executed by the power converter computing unit.

At operation 340, the process continues where the operational data is further used to perform diagnostics of the electric machine using a software module having diagnostics algorithm to be implemented within the processor of the power converter computing unit. In this method 300, the operational data is used to both control the power converter and to perform diagnostics of the electric machine.

As discussed above, the method 300 involves running additional software that can be added to one of the processors of the power converter computing unit, to passively run these diagnostic techniques using the operational data collected from the existing sensors. This eliminates the need for additional sensor hardware, data collection modules, data storage modules, and computational processing units.

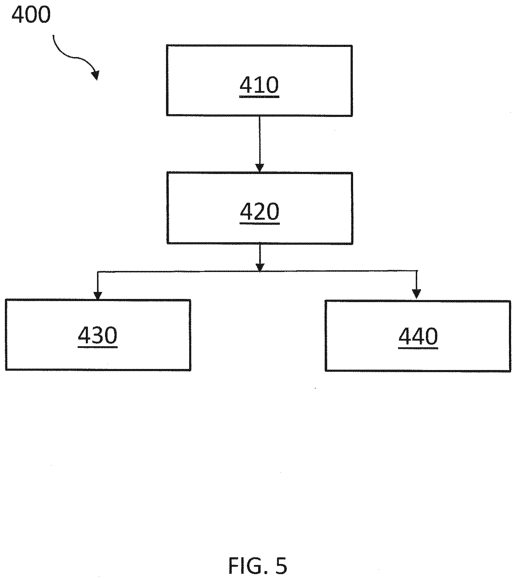

Fig. 5 is a flow diagram illustrating a method according to an alternative embodiment of the present invention. As shown in FIG. 5, the method 400 starts at operation 410 where electric power is supplied to the electric machine via the power converter and the power converter computing unit receives operational data from the electric machine via at least one sensor in communication with the electric machine.

The process continues to operation 420, where the power converter is controlled using control algorithms within at least one software module executed by the power converter computing unit. Followed by the diagnostic algorithms performed simultaneously in serial arrangement in operations 430 and 440 respectively.

Embodiments of the present invention provide advantages by leveraging existing hardware, simplifying the health monitoring system and reducing the total amount of control power consumption because a stand-alone diagnostic system is not employed.

This written description uses examples to disclose the invention including the best mode, and also to enable any person skilled in the art to practice the invention, including making and using any devices or apparatuses and performing any incorporated methods. The patentable scope of the invention is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal languages of the claims.

Various aspects and embodiments of the present invention are defined by the following numbered clauses:
1. A power converter for an electric machine, the power converter comprising:
   at least power converter computing unit executing one or more software modules;
   wherein the power converter is configured to (i) receive power from an electric power supply, supply power to the electric machine, and (ii) receive operational data from the electric machine via sensors in communication with the electric machine, and (iii) perform control of the power converter and diagnostics of the electric machine using the one or more software modules.
2. The power converter of clause 1, comprising an AC/AC, DC/AC, DC/DC or AC/DC power converter.
3. The power converter of any preceding clause, wherein the at least one power converter computing unit contains at least one processor wherein each processor may include one or more processing devices or cores for performing the control of the power converter and the software module for performing the diagnostics of the electric machine, using the operational data received.
4. The power converter of any preceding clause, wherein a plurality of power converter computing units are networked and which execute both the power converter control algorithms and the electric machine monitoring and diagnostics algorithms.
5. The power converter of any preceding clause, wherein the sensors comprise at least one sensor for sensing temperature, insulation system information, vibration information, wherein the operational data comprises temperature, insulation system information, vibration information and current and voltage measurements of the electric machine.

## Claims

1. A health monitoring system (100) for an electric machine (150), the health monitoring system (100) comprising:
a power converter (120) configured to receive power from an electric power supply, to supply electric power to the electric machine (150), and to receive operational data from the electric machine (150);
at least one power converter computing unit (130) disposed within the power converter (120) which executes one or more software modules (136, 137) for performing control for the power converter and diagnostics of the electric machine.

2. The health monitoring system (100) of claim 1, wherein the power converter (120) comprises an AC/AC, DC/DC, AC/DC or DC/AC power converter.

3. The health monitoring system (100) of claim 1 or 2, wherein the at least one power converter computing unit (130) contains at least one processor wherein each processor may include one or more processing devices or cores for performing the control of the power converter (120) and the software module for performing the diagnostics of the electric machine (150), using the operational data received from a plurality of sensors (200, 210, 212, 214, 216).

4. The health monitoring system (100) of claim 3, wherein a plurality of power converter computing units (130) are networked and which execute both the power converter control algorithms (136) and the electric machine monitoring and diagnostics algorithms (137).

5. The health monitoring system (100) of claim 3 or 4, wherein the sensors (200, 210, 212, 214 and 216) comprise at least one sensor for sensing temperature, insulation system information, vibration information, wherein the operational data comprises temperature, insulation system information, vibration information and current and voltage measurements of the electric machine (150).

6. A method for performing diagnostics of an electric machine (150) via a health monitoring system (100), the method comprising:
supplying electric power to a power converter (120) from an electric supply, supplying electric power to the electric machine (150) from the power converter (120), and receiving operational data from the electric machine (150) via sensors (200,210,212,214,216) in communication with the electric machine (150);
transmitting the operational data to a data acquisition unit locally within the power converter (120);
controlling the power converter (120) using control algorithms within one or more software modules (136,137) executed by at least one computing unit (130) of the power converter (120); and
performing diagnostics of the electric machine (150) using one or more software modules (136,137) having diagnostics algorithms to be executed by the at least one computing unit (130).

7. The method of claim 6, further comprising:
performing, by the at least one power converter computing unit (130) including at least one processor wherein each processor may include one or more processing devices or cores, control of the power converter (120) and the software module (136,137); and
performing the diagnostics of the electric machine (150), using the operational data received.

8. The method of claim 6 or 7, wherein
networking a plurality of power converter computing units (130);
simultaneously executing power converter control algorithms and electric machine monitoring and diagnostics algorithms.

9. The method of claim 6, 7 or 8, further comprising:
sensing temperature, insulation system information, vibration information, wherein the operational data comprises temperature, insulation system information, vibration information and current and voltage measurements of the electric machine (150).
